(19) Europäisches Patentamt
European Patent Office
Office européen des brevets

(11) **EP 2 728 625 B1**

(12) **EUROPEAN PATENT SPECIFICATION**

(45) Date of publication and mention
of the grant of the patent:
**29.11.2017 Bulletin 2017/48**

(51) Int Cl.:
***H01L 31/042*** *(2014.01)*    ***C03C 27/12*** *(2006.01)*
***C08K 5/00*** *(2006.01)*

(21) Application number: **12805060.6**

(22) Date of filing: **27.06.2012**

(86) International application number:
**PCT/JP2012/066447**

(87) International publication number:
**WO 2013/002292 (03.01.2013 Gazette 2013/01)**

(54) **SOLAR CELL SEALING MATERIAL AND LAMINATED GLASS INTERLAYER**

SOLARZELLENDICHTMATERIAL UND VERBUNDGLASZWISCHENSCHICHT

MATÉRIAU D'ÉTANCHÉITÉ POUR CELLULE SOLAIRE ET INTERCOUCHE EN VERRE STRATIFIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.06.2011   JP 2011143466**

(43) Date of publication of application:
**07.05.2014   Bulletin 2014/19**

(73) Proprietor: **Kuraray Co., Ltd.
Kurashiki-shi, Okayama 710-0801 (JP)**

(72) Inventors:
• **MUGURUMA Shinichi
Kurashiki-shi
Okayama 713-8550 (JP)**
• **MUKOSE Takashi
Kurashiki-shi
Okayama 713-8550 (JP)**

(74) Representative: **D Young & Co LLP
120 Holborn
London EC1N 2DY (GB)**

(56) References cited:
**WO-A1-03/033548      WO-A1-2010/041391
WO-A1-2010/041391    WO-A2-2009/047221
WO-A2-2009/047223    JP-A- 3 200 805
JP-A- 11 349 630**

• **DATABASE WPI Week 200016 Thomson
Scientific, London, GB; AN 2000-174193
XP002731919, -& JP H11 349630 A (DENKI
KAGAKU KOGYO KK) 21 December 1999
(1999-12-21)**
• **DATABASE WPI Week 199141 Thomson
Scientific, London, GB; AN 1991-300293
XP002731920, -& JP H03 200805 A (SEKISUI
CHEM IND CO LTD) 2 September 1991
(1991-09-02)**

**EP 2 728 625 B1**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The invention relates to an encapsulant for a solar cell that has good corrosion resistance property and a solar cell module produced therewith. The invention also relates to an interlayer film for laminated glass that has good corrosion resistance property and a laminated glass produced therewith.

BACKGROUND ART

In recent years, solar cells for converting sunlight directly to electric energy have been widely used and further developed for effective utilization of resources, from the aspect of prevention of environmental pollution, and other purposes.

A solar cell module usually has a photoelectric semiconductor layer (hereinafter also referred to as a solar cell) with a transparent cover for protecting it from external influences. Such a solar cell is usually placed between a glass plate and a hard cover plate or back sheet of glass or other materials and fixed using an encapsulant with adhesive properties.

In general, since solar cells are very fragile, an ethylene-vinyl acetate copolymer (EVA) or curable casting resin is proposed to be used as a raw material for the encapsulant (see Patent Literature 1 and Patent Literature 2). When uncured, these raw materials can be controlled to have low viscosity which enables the materials to surround a solar cell without inclusion of air bubbles. Subsequently, they can undergo a crosslinking reaction with a curing agent or a crosslinking agent, so that they can form a sealant with at least a certain level of mechanical strength. A solar cell module produced with EVA has a problem in that acetic acid produced by hydrolysis or thermal decomposition of EVA can corrode metal components. In the case of using EVA, another problem occurs in that lamination needs to be performed while the crosslinking reaction is allowed to proceed, which makes the production by roll-to-roll process difficult. The production of a solar cell module using curable casting resin has difficulty in controlling the process of embedding solar cells and curing. Thus, such a technique is hardly used in practice. In addition, some types of curable casting resin can produce bubbles or cause delamination after several years.

Thus, it is proposed to use polyvinyl butyral (PVB), a thermoplastic resin, as an encapsulant (see Patent Literature 3 and Patent Literature 4). PVB is advantageous in that it is less likely to corrode metal components because the content of the acetic acid unit capable of producing an acid component is lower in it than in EVA. In addition, PVB, which is a thermoplastic resin, has high viscosity at the flow beginning temperature and thus is less likely to flow out of a glass end during lamination and thus less likely to smear a device or a glass end face. From a mechanical point of view, a PVB-based encapsulant also has high adhesion to glass and high penetration resistance. In addition, PVB does not need any crosslinking process, so that a solar cell module can be produced with PVB by a roll-to-roll process.

CITATION LIST

PATENT LITERATURE

Patent Literature 1: JP 58-23870 A

Patent Literature 2: JP 06-177412 A

Patent Literature 3: JP 2006-13505 A

Patent Literature 4: WO 2009/151952 A2

SUMMARY OF INVENTION

TECHNICAL PROBLEM

However, the conventional encapsulants described in Patent Literature 3 and Patent Literature 4 usually contain a relatively large amount of a plasticizer as an essential component in addition to PVB so that they can have high handleability such as an ability to be wound into a roll. Such a plasticizer tends to increase the water-vapor permeability of the encapsulants. When used at high temperature and high humidity for a long period of time, therefore, the encapsulants can corrode metal components to cause discoloration of a solar cell module and a reduction in its power generation efficiency. In the conventional art, water-resistant sealing such as covering the end of a solar cell module with a frame is performed to prevent such a reduction in the power generation efficiency. Now, in view of environment and cost, there has been a demand for a frame-less solar cell module with a long life, and an encapsulant with improved corrosion resistance properties has been desired as a means for achieving such a solar cell module. A laminated glass produced using a PVB-based interlayer film in combination with a functional material such as a heat shielding material or an electrochromic material may also have a problem in that the acid component can corrode the functional material in the same manner. Thus, an interlayer film with improved anticorrosive properties for laminated glass has been desired.

Thus, an object of the invention is to provide an encapsulant for a solar cell which has high corrosion resistance property and can form a solar cell module with a long life. Another object of the invention is to provide an inexpensive, long-life, solar cell module.

A further object of the invention is to provide an interlayer film for laminated glass, which is has high corrosion resistance property and can form a laminated glass with long-term durability. A further object of the invention is to provide an inexpensive laminate glass with long-term durability.

SOLUTION TO PROBLEM

It is known that corrosion of metal components is generally an oxidation reaction which proceeds by the presence of oxygen or water. Suppressing the infiltration of oxygen, water, and so on, in other words, a corrosion resistance property is important to increase the life of a solar cell module or to provide long-term durability for a laminated glass.

Based on these findings, the inventors have made various studies. As a result, the inventors have found that when an encapsulant for a solar cell or an interlayer film for laminated glass is produced with a polyvinyl acetal material having low water-vapor permeability and having a low content of chlorine so that acid generation can be suppressed (chlorine would otherwise accelerate corrosion of metal components), the resulting encapsulant for a solar cell or the resulting interlayer film for laminated glass can be highly corrosion resistance and can also form a solar cell module with a long life or a laminated glass with long-term durability.

Specifically, the invention is directed to an encapsulant for a solar cell or an interlayer film for laminated glass, which includes a material having a polyvinyl acetal content of 40% by mass or more and a chlorine content of 25 ppm or less and having a plasticizer content of 10 parts by mass or less based on 100 parts by mass of polyvinyl acetal.

The polyvinyl acetal preferably has an average degree of polymerization of 100 to 5,000, more preferably 600 to 1,500. The encapsulant for a solar cell or the interlayer film for laminated glass preferably has an amount of acid component change of 1.00 KOHmg/g or less after hot water test, wherein the amount of acid component change is expressed by formula (1):
[Mathematical Formula 1]

$$\text{(Amount of acid component change after hot water test)} = A - B \quad (1)$$

[wherein, in formula (1), A represent a value (in units of KOHmg/g) obtained by dividing, by the mass (in units of g) of the encapsulant for a solar cell or the interlayer film for laminated glass before immersion of the material or the film in hot water at 85°C for 2,000 hours, the mass (in units of mg) of potassium hydroxide required to neutralize acid components present in both of the water and the encapsulant for a solar cell or the interlayer film for laminated glass after the immersion of the material or the film in hot water at 85°C for 2,000 hours, and B represents a value (in units of KOHmg/g) obtained by dividing, by the mass (in units of g) of the encapsulant for a solar cell or the interlayer film for laminated glass before the immersion, the mass (in units of mg) of potassium hydroxide required to neutralize acid components present in the encapsulant for a solar cell or the interlayer film for laminated glass before the immersion.]

Such an encapsulant for a solar cell or such an interlayer film for laminated glass can be obtained by a production method including performing acetalization of polyvinyl alcohol with an aldehyde in the presence of a chlorine-free catalyst to obtain the polyvinyl acetal. The chlorine-free catalyst is preferably nitric acid.

The invention is also directed to a solar cell module including the encapsulant for a solar cell. Such a solar cell module preferably further includes a metal layer, and preferably has a structure in which at least part of the encapsulant for a solar cell is in contact with the metal layer.

The invention is also directed to a laminated glass including the interlayer film for laminated glass. Such a laminated glass preferably further includes a functional material, and preferably has a structure in which at least part of the interlayer film for laminated glass is in contact with the functional material.

ADVANTAGEOUS EFFECTS ON INVENTION

Even when there is no water-resistant sealing at ends, corrosion of metal components can be reduced using the encapsulant for a solar cell of the invention. Thus, the encapsulant for a solar cell of the invention can form a long-life, solar cell module that is less likely to be discolored even when used for a long period of time at high temperature and high humidity. This makes it possible to reduce cost and increase service life, so that power generation cost can be reduced. Even when used together with a functional material such as a heat shielding material or an electrochromic material, the interlayer film of the invention for laminated glass can suppress the corrosion of such a material. Thus, the interlayer film of the invention can form laminated glass products that are less likely to be discolored, have high quality, and have high durability so that they will not undergo delamination over a long period of time.

BRIEF DESCRIPTION OF DRAWING

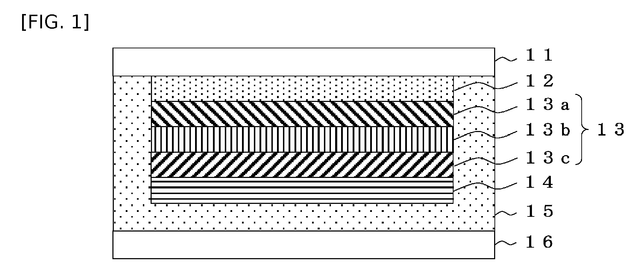

Fig. 1 is a cross-sectional view of an example of a common thin-film silicon solar cell module.

DESCRIPTION OF EMBODIMENTS

The encapsulant for a solar cell of the invention or the interlayer film of the invention for laminated glass includes a material having a polyvinyl acetal content of 40% by mass or more and a chlorine content of 25 ppm or less and having a plasticizer content of 10 parts by mass or less based on 100 parts by mass of polyvinyl acetal. Hereinafter, embodiments of the invention will be described. In the description below, some specific materials performing specific functions will be listed as examples. It will be understood that such listing is not intended to limit the invention. Unless otherwise stated, such listed materials may be used singly or in combination of two or more.

[Polyvinyl acetal]

The encapsulant for a solar cell of the invention or the interlayer film of the invention for laminated glass contains polyvinyl acetal as a main component. The polyvinyl acetal content is 40% by mass or more, which is important, preferably 50% by mass or more, more preferably 60% by mass or more, even more preferably 80% by mass or more. If the polyvinyl acetal content is less than 40% by mass, the material or the film would have insufficient corrosive resistance properties or insufficient adhesion to glass. The encapsulant for a solar cell of the invention or the interlayer film of the invention for laminated glass may also include a mixture of polyvinyl acetal and any other resin or may include a laminate of polyvinyl acetal and any other resin without departing from the gist of the invention. An inorganic material (such as titanium oxide or talc) may also be added to the material or the film.

The polyvinyl acetal preferably has an average degree of acetalization of 40 to 90% by mole. If it is less than 40% by mole, the water absorption of the encapsulant for a solar cell or the interlayer film for laminated glass may undesirably increase. If it is more than 90% by mole, the reaction to produce the polyvinyl acetal can require a long time, which is not preferable for the process of reaction. The average degree of acetalization is preferably from 60 to 85% by mole, more preferably from 65 to 80% by mole in view of water resistance. The average degree of acetalization is based on the content of the vinyl acetal component in the polyvinyl acetal as described below.

The polyvinyl acetal preferably has a vinyl acetate content of 20% by mole or less, more preferably 5% by mole or less, even more preferably 2% by mole or less. If the vinyl acetate content is more than 20% by mole, blocking can occur during the production of the polyvinyl acetal to make it difficult to complete the production, or the acetate groups can be hydrolyzed into carboxyl groups at high temperature and high humidity, which is not preferred.

The polyvinyl acetal is generally composed of components of vinyl acetal, vinyl alcohol, and vinyl acetate. For example, the content of each of these components can be determined based on JIS K 6728 (1977) "Polyvinyl Butyral Testing Methods" or nuclear magnetic resonance (NMR) method.

When the polyvinyl acetal contains other components than the vinyl acetal component, the vinyl acetal component content can be generally calculated as follows. The amount of a vinyl alcohol component and the amount of a vinyl acetate component are measured. These amounts are subtracted from the total amount of the polyvinyl acetal, so that the amount of the vinyl acetal component is calculated as a balance.

The polyvinyl acetal used in the invention can be produced by reaction of polyvinyl alcohol with an aldehyde as described below. In such a case, the polyvinyl acetal can be produced by known methods.

Polyvinyl alcohol, which is used as a raw material for the polyvinyl acetal, can be typically obtained by polymerizing a vinyl ester monomer and saponifying the resulting polymer. The vinyl ester monomer can be polymerized using a conventionally known method such as solution polymerization, bulk polymerization, suspension polymerization, or emulsion polymerization. A polymerization initiator may be used, which is appropriately selected from an azo initiator, a peroxide initiator, a redox initiator, etc., depending on the polymerization method. The saponification may be alcoholysis or hydrolysis using a conventionally known alkali or acid catalyst. In particular, saponification using a methanol solvent and a sodium hydroxide (NaOH) catalyst is convenient and most preferred.

The vinyl acetate content of the resulting polyvinyl acetal preferably falls within the range mentioned above. For this purpose, the polyvinyl alcohol as a raw material preferably has a degree of saponification of 80% by mole or more, more preferably 95% by mole or more, even more preferably 98% by mole or more.

Examples of the vinyl ester monomer include vinyl formate, vinyl acetate, vinyl propionate, vinyl butyrate, vinyl isobutyrate, vinyl pivalate, vinyl versatate, vinyl caproate, vinyl caprylate, vinyl laurate, vinyl palmitate, vinyl stearate, vinyl oleate, and vinyl benzoate. Among them, vinyl acetate is preferred. The vinyl ester monomer may be copolymerized with any other monomer such as an α-olefin within the range that does not depart from the gist of the invention.

The polyvinyl alcohol as a raw material for the polyvinyl acetal preferably has an average degree of polymerization of 100 to 5,000, more preferably 400 to 3,000, even more preferably 600 to 2,500, further more preferably 700 to 2,300, most preferably 750 to 2,000. If the polyvinyl alcohol has too low an average degree of polymerization, the resulting solar cell module may have lower penetration resistance. or lower creep resistance, specifically, lower creep resistance under high-temperature, high-humidity conditions such as 85°C, 85% RH. If the average degree of polymerization is more than 5,000, the resin film may be difficult to mold. The resulting encapsulant for a solar cell or the resulting interlayer film for laminated glass should have higher suitability for lamination to form a solar cell module with a better appearance or a laminated glass with a better appearance. For this purpose, the polyvinyl alcohol preferably has an average degree of polymerization of 1,500 or less, more preferably 1,100 or less, even more preferably 1,000 or less. The average degree of polymerization of the polyvinyl acetal is equal to the average degree of polymerization of the polyvinyl alcohol as the raw material. Thus, the preferred average degree of polymerization of the polyvinyl alcohol corresponds to the preferred average degree of polymerization of the polyvinyl acetal.

For example, the average degree of polymerization of the polyvinyl alcohol can be determined based on JIS K 6726 "Polyvinyl Alcohol Testing Methods."

The polyvinyl acetal may be produced using any type of solvent. For industrial mass-production of the polyvinyl acetal, water is preferably used as the solvent, and it is preferable to sufficiently dissolve the polyvinyl alcohol in water at a high temperature, typically, a temperature of 90°C or higher, in advance before the reaction. The aqueous solution of the polyvinyl alcohol preferably has a concentration of 5 to 40% by mass, more preferably 6 to 20% by mass, even more preferably 7 to 15% by mass. If the concentration of the aqueous solution is too low, productivity may be low. If the concentration of the aqueous solution is too high, stirring can be difficult during the reaction, or gelation can occur due to hydrogen bonding between the polyvinyl alcohol molecules to cause an uneven reaction, which is not preferred.

The polyvinyl acetal can be produced by adding an aldehyde to the aqueous solution of the polyvinyl alcohol and allowing the aldehyde to react with the polyvinyl alcohol. In this process, a chlorine-free catalyst is preferably used to reduce the chlorine content of the polyvinyl acetal, although a chloride catalyst such as hydrochloric acid may be used. Such a chlorine-free catalyst may be any of an organic acid and an inorganic acid, examples of which include acetic acid, p-toluenesulfonic acid, nitric acid, sulfuric acid, and carbonic acid. Among them, sulfuric acid and nitric acid are preferred because they can achieve sufficient reaction speed and can be easily washed off after the reaction, and nitric acid is more preferred because it is easy to handle. The concentration of the catalyst in the polyvinyl alcohol aqueous solution after the catalyst is added is preferably from 0.01 to 5 mol/L, more preferably from 0.1 to 2 mol/L, when the catalyst is sulfuric acid or nitric acid, although it depends on the catalyst type. If the concentration of the catalyst is too low, the reaction speed can be low so that it can take a long time to obtain polyvinyl acetal with a desired degree of acetalization or desired physical properties, which is not preferred. If the concentration of the catalyst is too high, it can be difficult to control the acetalization reaction, and an aldehyde trimer can be easily produced, which is not preferred.

The reaction may be performed using formaldehyde, acetaldehyde, propionaldehyde, butylaldehyde, hexylaldehyde, benzaldehyde, or other aldehydes. The aldehyde is preferably an aldehyde compound of 1 to 12 carbon atoms, more preferably a saturated alkyl aldehyde compound of 1 to 6 carbon atoms, even more preferably a saturated alkyl aldehyde compound of 1 to 4 carbon atoms. In view of the mechanical properties of the encapsulant for a solar cell or the interlayer film for laminated glass, butylaldehyde is particularly preferred. The aldehydes may be used singly or in combination of two or more. In particular, to control the glass transition temperature of the polyvinyl acetal, butylaldehyde is preferably used in combination with acetaldehyde. In addition, a small amount of a polyfunctional aldehyde or an aldehyde with any other functional group may also be used in combination with the aldehyde described above as long as it makes up 20% by mass or less of the total amount of all the aldehydes used.

The acetalization reaction may be performed using a known process, such as a process including adding the catalyst to the polyvinyl alcohol aqueous solution and then adding the aldehyde to the aqueous solution or a process including first adding the aldehyde to the aqueous solution and then adding the catalyst to the aqueous solution. Examples of such a process also include a process of adding the aldehyde or the catalyst at a time, gradually, or in parts and a process of adding a solution of a mixture of the polyvinyl alcohol aqueous solution and an aldehyde or a catalyst to a solution containing a catalyst or an aldehyde.

The reaction temperature of the acetalization reaction is not restricted. To form an encapsulant for a solar cell with improved anticorrosive properties or to form an interlayer film with improved anticorrosive properties for laminated glass, porous polyvinyl acetal should be produced, which is easy to clean after the reaction. For this purpose, the acetalization reaction is preferably performed at a relatively low temperature of 0 to 40°C, more preferably 5 to 20°C, until polyvinyl acetal particles precipitate during the reaction. If the reaction temperature is higher than 40°C, polyvinyl acetal may be fused and less likely to be porous. After the reaction is performed at a relatively low temperature of 0 to 40°C, the reaction is preferably performed at a temperature of 50 to 80°C, more preferably 65 to 75°C, in order to increase the productivity by accelerating the reaction.

After the acetalization reaction is completed, the remaining aldehyde and catalyst may be removed using a known process. The polyvinyl acetal obtained by the reaction should be neutralized with an alkali compound. Before the neutralization, the aldehyde remaining in the polyvinyl acetal is preferably removed as much as possible. Useful methods for this purpose include a method of accelerating the reaction under conditions capable of increasing the rate of the reaction of the aldehyde, a method of cleaning sufficiently with water or a mixed solvent of water and an alcohol, and a method of chemically treating the aldehyde. Examples of the alkali compound used for the neutralization include alkali metal hydroxides such as sodium hydroxide and potassium hydroxide and amine compounds such as ammonia, triethylamine, and pyridine. Among them, alkali metal hydroxides are particularly preferred, which have a small effect on the adhesion to glass.

The polyvinyl acetal obtained by the method described above can be decomposed by an acid in the presence of water, so that an aldehyde can be produced. Thus, the alkali titer of the obtained polyvinyl acetal is preferably adjusted to be positive. After the neutralization with the alkali, the alkali titer of the polyvinyl acetal is preferably from 0.1 to 30, more preferably from 1 to 20, even more preferably from 1 to 10. If the alkali titer is less than 0.1, hydrolysis may easily occur. On the other hand, if the alkali titer is more than 30, discoloration may easily occur during the process of forming the polyvinyl acetal into a sheet. As used herein, the term "alkali titer" refers to the amount (mL) of 0.01 mol/L hydrochloric acid required to neutralize the alkali component in 100 g of the polyvinyl acetal by titration.

In addition, the acid value of the polyvinyl acetal obtained by the method described above is preferably 0.50 KOHmg/g or less, more preferably 0.30 KOHmg/g or less, even more preferably 0.10 KOHmg/g or less, further more preferably 0.06 KOHmg/g or less. If the acid value of the polyvinyl acetal is more than 0.50 KOHmg/g, a relatively large amount of the acid component may cause discoloration of the resulting encapsulant for a solar cell or the resulting interlayer film for laminated glass, or the electrode of the resulting solar cell module may corrode, which may cause a reduction in life. As used herein, the acid value of the polyvinyl acetal is a value determined according to JIS K 6728 (1977).

[Plasticizer]

In the invention, the plasticizer content is very important. The plasticizer content of the encapsulant for a solar cell of the invention or the interlayer film of the invention for laminated glass is 10 parts by mass or less, which is important, preferably 8 parts by mass or less, more preferably 5 parts by mass or less, even more preferably 2 parts by mass or less, based on 100 parts by mass of the polyvinyl acetal. The plasticizer content may be 0 parts by mass (in other words, there is no need to use any plasticizer in some cases). If the plasticizer content is more than 10 parts by mass, an acid component present as an impurity in the plasticizer may increase, or the plasticizing effect may cause an increase in water-vapor permeability so that water may easily enter the material, which is not preferred because a problem such as a power reduction or discoloration may occur in a solar cell module at high temperature and high humidity.

The acid value of the plasticizer used in the invention is preferably 0.50 KOHmg/g or less, more preferably 0.30 KOHmg/g or less, even more preferably 0.10 KOHmg/g or less, further more preferably 0.06 KOHmg/g or less. If the acid value of the plasticizer is more than 0.50 KOHmg/g, the encapsulant for a solar cell or the interlayer film for laminated glass may be discolored or decomposed to generate gas, which may reduce the life of the resulting solar cell module or may reduce the long-term durability of the interlayer film for laminated glass. As used herein, the acid value of the plasticizer is a value determined according to JIS K 6728 (1977).

Examples of the plasticizer described above include, but are not limited to, triethylene glycol di(2-ethyl hexanoate) (3GO), tetraethylene glycol di(2-ethyl hexanoate), di(2-butoxyethyl) adipate (DBEA), di(2-butoxyethyl) sebacate (DBES), di(2-butoxyethyl) azelate, di(2-butoxyethyl) glutarate, di(2-butoxyethyl) phthalate, di(2-butoxyethoxyethyl) adipate (DBEEA), di(2-butoxyethoxyethyl) sebacate (DBEES), di(2-butoxyethoxyethyl) azelate, di(2-butoxyethoxyethyl) glutarate, di(2-butoxyethoxyethyl) phthalate, di(2-hexoxyethyl) adipate, di(2-hexoxyethyl) sebacate, di(2-hexoxyethyl) azelate, di(2-hexoxyethyl) glutarate, di(2-hexoxyethoxyethyl) adipate, di(2-hexoxyethoxyethyl) sebacate, di(2-hexoxyethoxyethyl) azelate, di(2-hexoxyethoxyethyl) glutarate, and diisononyl 1,2-cyclohexanedicarboxylate (DINCH). Particularly preferred is a plasticizer in which the sum of the numbers of carbon and oxygen atoms constituting the plasticizer molecule is more than 28. If the sum of the numbers of carbon and oxygen atoms constituting the plasticizer molecule is 28 or less, thermal decomposition or hydrolysis may occur particularly at high temperature and high humidity to increase the acid value, so that the encapsulant for a solar cell or the interlayer film for laminated glass may tend to have a higher acid concentration. Preferred examples include triethylene glycol di(2-ethyl hexanoate) (3GO), tetraethylene glycol di(2-ethyl hexanoate), di(2-butoxyethoxyethyl) adipate (DBEEA), di(2-butoxyethoxyethyl) sebacate (DBEES), and diisononyl 1,2-cyclohexanedicarboxylate (DINCH). Among them, triethylene glycol di(2-ethyl hexanoate) (3GO) and diisononyl 1,2-cyclohexanedicarboxylate (DINCH) are preferred because a small amount of them can produce the desired plasticizing effect without reducing the anticorrosive properties of the solar sealing material or the interlayer film for laminated glass. Such plasticizers may be used singly or in combination of two or more.

[Other additives]

If necessary, the encapsulant for a solar cell of the invention or the interlayer film of the invention for laminated glass may contain an adhesive strength adjusting agent, an antioxidant, an ultraviolet absorber, a light stabilizer, an anti-blocking agent, a pigment, a dye, a functional inorganic compound, or other additives as long as the effects of the invention are not impaired.

For example, the adhesive strength adjusting agent disclosed in WO 03/033583 A may be used, and an alkali metal salt or an alkaline-earth metal salt is preferably used as the adhesive strength adjusting agent, examples of which include salts of potassium, sodium, magnesium, or the like. Examples of the salts include salts of organic acids including carboxylic acids such as octanoic acid, hexanoic acid, butyric acid, acetic acid, and formic acid; and salts of inorganic acids such as hydrochloric acid and nitric acid. The optimum amount of addition of the adhesive strength adjusting agent varies with the type of the additive used. In general, the amount of addition of the adhesive strength adjusting agent is preferably controlled in such a manner that the resulting encapsulant for a solar cell or the resulting interlayer film for laminated glass can have an adhesive strength of 3 to 10 in general, an adhesive strength of 3 to 6 when particularly high penetration resistance. is necessary, or an adhesive strength of 7 to 10 when high glass-shatter resistance is necessary, to glass in the Pummel test (see, for example, WO 03/033583 A). When high glass-shatter resistance is required, no addition of the adhesive strength adjusting agent is also a useful method. A silane coupling agent is one of a variety of additives for improving the adhesion. A silane coupling agent is preferably added in an amount of 0.01 to 5% by mass based on the mass of the encapsulant for a solar cell or the interlayer film for laminated glass.

Examples of the antioxidant include phenolic antioxidants, phosphorus-containing antioxidants, and sulfur-containing antioxidants. Among them, phenolic antioxidants are preferred, and alkyl-substituted phenolic antioxidants are particularly preferred. These antioxidants may be used singly or in combination two or more. The antioxidant is preferably added in an amount of 0.001 to 5 parts by mass, more preferably 0.01 to 1 part by mass, based on 100 parts by mass of the polyvinyl acetal.

Any known ultraviolet absorber may be used, such as a benzotriazole ultraviolet absorber, a hindered amine ultraviolet absorber, or a benzoate ultraviolet absorber. The ultraviolet absorber is preferably added in an amount of 10 to 50,000 ppm, more preferably 100 to 10,000 ppm, based on the mass of the polyvinyl acetal. The ultraviolet absorbers may be used singly or in combination of two or more.

The light stabilizer may be a hindered amine compound such as ADK STAB LA-57 (trade name) manufactured by ADEKA CORPORATION.

Examples of the functional inorganic compound include a light reflecting material, a light absorbing material, a thermal conduction improving material, an electrical property improving material, a gas barrier improving material, and a mechanical property improving material.

[Encapsulant for a solar cell and interlayer film for laminated glass]

The method for producing the encapsulant for a solar cell of the invention or the interlayer film of the invention for laminated glass may be, but not limited to, a method including uniformly kneading the polyvinyl acetal alone or optionally adding a predetermined amount of a plasticizer and/or other additives to the polyvinyl acetal and uniformly kneading the mixture; and then forming the kneaded material into a sheet by a known film forming method such as extrusion, calendering, pressing, casting, or inflation, so that the sheet can be obtained as the encapsulant for a solar cell or the interlayer film for laminated glass.

Among the known film forming methods, the method of forming a sheet using an extruder is particularly preferably employed. During the extrusion, the resin temperature is preferably from 150 to 250°C, more preferably from 170 to 230°C. If the resin temperature is too high, the polyvinyl acetal can be decomposed so that the content of volatile substances may tend to increase. On the other hand, if the resin temperature is too low, the content of volatile substances may also tend to increase. To remove volatile substances efficiently, it is preferable to remove the volatile substances from the vent of the extruder by means of reduced pressure.

The encapsulant for a solar cell of the invention or the interlayer film of the invention for laminated glass has a chlorine content of 25 ppm or less, which is important, preferably 20 ppm or less, more preferably 10 ppm or less, even more preferably 6 ppm or less, most preferably 3 ppm or less, based on the mass of the encapsulant for a solar cell or the interlayer film for laminated glass. If the chlorine content is more than 25 ppm, metal components can corrode at high temperature and high humidity to easily cause discoloration of a solar cell module, so that the power of the solar cell module can decrease. On the other hand, the chlorine content does not have a specific lower limit. For production reasons, however, the chlorine content may have a lower limit of 0.1 ppm. The chlorine content can be measured by potentiometric titration as described below in EXAMPLES. Specifically, the titer can be determined by detecting the change in electric conductivity using a 0.001 mol/L silver nitrate aqueous solution as a titration solution, and the chloride ion concentration of the encapsulant for a solar cell or the interlayer film for laminated glass can be calculated as the chlorine content from the titer.

As described above, the encapsulant for a solar cell or the interlayer film for laminated glass should have a chlorine content in the above range. For example, the method of setting the chlorine content in the above range may be a method of reducing the chlorine content of the polyvinyl acetal to be used, specifically, a method of using a chlorine-free catalyst in the acetalization of polyvinyl alcohol with an aldehyde. The above mentioned chlorine-free catalysts may be used. Sulfuric acid or nitric acid is preferred because they can achieve sufficient reaction speed and can be easily washed off after the reaction, and nitric acid is more preferred because it is particularly easy to handle. Even when a chlorine-containing catalyst such as hydrochloric acid is used, the chlorine content can be reduced by repetition of washing with water or the like after the filtration of the polyvinyl acetal obtained by acetalization and/or after the neutralization of the polyvinyl acetal.

The encapsulant for a solar cell of the invention or the interlayer film of the invention for laminated glass preferably has an amount of acid component change of 1.00 KOHmg/g or less, more preferably 0.70 KOHmg/g or less, even more preferably 0.50 KOHmg/g or less, after hot water test, wherein the amount of acid component change is expressed by formula (1) below. If the amount of acid component change after hot water test is more than 1.00 KOHmg/g, metal components can corrode at high temperature and high humidity to easily cause discoloration of a solar cell module, so that the power of the solar cell module may decrease, which is not preferred. The amount of acid component change after hot water test is generally 0 KOHmg/g or more although it may be a negative value.

[Mathematical Formula 2]

$$\text{(Amount of acid component change after hot water test)} = A - B \quad (1)$$

In formula (1), A represents a value (in units of KOHmg/g) obtained by dividing, by the mass (in units of g) of the encapsulant for a solar cell as the measuring object or the interlayer film as the measuring object for laminated glass before immersion of the material or the film in hot water at 85°C for 2,000 hours, the mass (in units of mg) of potassium hydroxide required to neutralize acid components present in both of the water and the encapsulant for a solar cell or the interlayer film for laminated glass after the immersion of the material or the film in hot water at 85°C for 2,000 hours, and B represents a value (in units of KOHmg/g) obtained by dividing, by the mass (in units of g) of the encapsulant for a solar cell or the interlayer film for laminated glass before the immersion, the mass (in units of mg) of potassium hydroxide required to neutralize acid components present in the encapsulant for a solar cell or the interlayer film for laminated glass before the immersion.

Hereinafter, a method for determining the amount of acid component change after hot water test will be described. First, the acid value of the encapsulant for a solar cell as the measuring object or the acid value of the interlayer film as the measuring object for laminated glass is measured according to JIS K 6728 (1977). The resulting acid value is used as it is as B (in units of KOHmg/g) in the above formula. Subsequently, 5 g of the encapsulant for a solar cell as the measuring object or 5 g of the interlayer film as the measuring object for laminated glass is immersed in 50 mL of water and subjected to immersion treatment at 85°C for 2,000 hours. After the immersion treatment for 2,000 hours, the encapsulant for a solar cell or the interlayer film for laminated glass is taken out and measured for acid value according to JIS K 6728 (1977). The resulting acid value (in units of KOHmg/g) is multiplied by the mass (in units of g) of the encapsulant for a solar cell or the interlayer film for laminated glass after the immersion treatment for 2,000 hours to yield a value A1 (in units of KOHmg). After the immersion treatment for 2,000 hours, the encapsulant for a solar cell or the interlayer film for laminated glass is taken out of the water, and subsequently, the acid value of the water is measured according to JIS K 6728 (1977) (in which 0.02 mol/L sodium hydroxide is used as the titration solution, and after the titration, conversion calculation is made to obtain the mass of potassium hydroxide, of which the number of moles is equal to the number of moles of sodium hydroxide used for the titration). The resulting acid value (in units of KOHmg/g) is multiplied by the mass (in units of g) of the water to yield a value A2 (in units of KOHmg). The sum of A1 and A2 is then divided by the mass of the encapsulant for a solar cell or the interlayer film for laminated glass before the immersion. The resulting quotient is used as A (in units of KOHmg/g) in the above formula.

To set the amount of acid component change after hot water test in the above range expressed by formula (1), it is important to reduce the acid content of the polyvinyl acetal to be used. Examples of methods of reducing the acid content include methods of removing the acid catalyst for acetalization by sufficient neutralization and washing and methods of adding a pH-adjusting buffer. The acid content can also be reduced by reducing the amount of the plasticizer used. Among these methods, the addition of a pH-adjusting buffer is preferred because it can suppress an acetal-removing reaction during the hot water immersion and can also suppress the subsequent oxidation reaction, so that the production of acid components can be suppressed.

Known pH-adjusting buffers may be used, such as citric acid-citrate buffers (such as a combination of citric acid and sodium citrate), acetic acid-acetate buffers (such as a combination of acetic acid and sodium acetate, potassium acetate, or magnesium acetate), butyric acid-acetate buffers (such as a combination of butyric acid and sodium acetate, potassium acetate, or magnesium acetate), citric acid-phosphate buffers (such as a combination of citric acid and disodium hydrogen phosphate), phosphate-phosphate buffers (such as a combination of sodium dihydrogen phosphate and disodium hydrogen phosphate), tris(hyroxymethyl)aminomethane-hydrochloric acid buffers, glycine-sodium hydroxide buffers, and carbonate-bicarbonate buffers (such as a combination of sodium carbonate and sodium bicarbonate). The type of buffer to be used may be appropriately selected depending on the corrosion resistance of the metal or the metal oxide to be in contact with the buffer. Buffers with a pH in the range of 5 to 9 are preferred, and acetic acid-acetate buffers, butyric acid-acetate buffers, or phosphate-phosphate buffers are particularly preferred in view of pH, handleability, and cost.

The amount of addition of the pH-adjusting buffer is preferably, but not limited to, 1 to 50,000 ppm, more preferably 5 to 10,000 ppm, even more preferably 10 to 5,000 ppm, further more preferably 15 to 2,000 ppm, based on the mass of the polyvinyl acetal.

A relief structure is also preferably formed on the surface of the encapsulant for a solar cell of the invention or the interlayer film of the invention for laminated glass by a conventionally known method such as melt fracture or embossing. The shape obtained by melt fracture or embossing is not limited and may be a conventionally known one.

The thickness of the encapsulant for a solar cell is preferably, but not limited to, 20 to 10,000 $\mu$m, more preferably 100 to 3,000 $\mu$m, even more preferably 200 to 1,000 $\mu$m. The thickness of the interlayer film for laminated glass is preferably, but not limited to, 20 to 10,000 $\mu$m, more preferably 100 to 3,000 $\mu$m. Too thin an encapsulant for a solar cell or too thin an interlayer film for laminated glass may fail to be well laminated in the process of forming a solar cell module or a laminated glass, and too thick one may be high cost, which is not preferred.

The encapsulant for a solar cell of the invention can be used to encapsulate between a solar cell and a front transparent protective member and/or a rear protective member in forming a solar cell module. Such a solar cell module may be of various types. Examples of such a solar cell module include a structure having a solar cell sandwiched from both sides by encapsulants, such as a structure including a front transparent protective member, a front encapsulant, a solar cell, a rear encapsulant, and a rear protective member arranged in this order; a structure including a front transparent protective member, a solar cell, an encapsulant, and a rear protective member arranged in this order (super-straight structure); and a structure including a front transparent protective member, an encapsulant, a solar cell, and a rear protective member arranged in this order (sub-straight structure).

The solar cell as a component of the solar cell module may be of any type, such as a silicon-based solar cell such as a single crystal silicon solar cell, a polycrystalline silicon solar cell, or an amorphous silicon solar cell; a periodic table III-V or II-VI group compound semiconductor-based solar cell such as a gallium-arsenide solar cell, a CIGS solar cell, or a cadmium-tellurium solar cell; or an organic solar cell such as a dye-sensitized solar cell or an organic thin-film solar cell.

As illustrated in Fig. 1, a solar cell module having a thin film silicon-based solar cell may have a super-straight structure including a glass substrate 11 as a front transparent protective member, a glass substrate 16 as a rear protective member (back cover), a polyvinyl butyral-containing encapsulant 15, and a solar cell, such as a silicon power generation device, encapsulated with the encapsulant 15 between the glass substrates 11 and 16. In this structure, the solar cell corresponds to a part composed of a transparent electrode layer 12, a photoelectric conversion unit 13, and a back electrode 14. The photoelectric conversion unit 13 typically includes a p-type amorphous Si film 13a as a p-type layer, an i-type amorphous Si film 13b as an i-type layer, and an n-type amorphous Si film 13c as an n-type layer. The encapsulant for a solar cell of the invention, which is highly anticorrosive, is used as the encapsulant 15. When the back electrode 14 in contact with the encapsulant 15 is a layer of metal such as silver, aluminum, titanium, or molybdenum, in other words when at least part of the encapsulant for a solar cell is in contact with a metal layer, the encapsulant for a solar cell of the invention is useful in that it is more effective in reducing the corrosion of the metal component.

Corrosion of metal components is a cause of a reduction in the power generation efficiency of a solar cell module. When the encapsulant for a solar cell of the invention is used in a solar cell module with a metal layer in contact with the encapsulant, however, the reduction in the power generation efficiency can be significantly suppressed. The encapsulant for a solar cell of the invention with such high anticorrosive properties is useful not only in the above solar cell module with a metal layer in contact with the encapsulant but also in a solar cell module with a metal-containing wire in contact with the encapsulant.

When a solar cell module having the encapsulant for a solar cell of the invention in direct contact with its electrode is exposed to an environment at 85°C and 85%RH for 2,000 hours, the length of a discolored part of its solar cell having undergone corrosion or the like is preferably 5 mm or less, more preferably 3 mm or less, even more preferably 2 mm or less, from its end. If the discolored (rusted) part is over 5 mm long, the conversion efficiency of the solar cell module can significantly decrease, which is not preferred.

The front transparent protective member as a component of the solar cell module may be made of glass, acrylic resin, polycarbonate, polyester, fluororesin, or other materials. Among them, glass is preferred in view of water barrier properties and cost. The rear protective member may be any of monolayer or multilayer sheets such as metal films and a variety of thermoplastic resin films. More specifically, the rear protective member may be a monolayer or multilayer sheet made of a metal such as tin, aluminum, or stainless steel, an inorganic material such as glass, polyester, inorganic vapor-deposited polyester, fluororesin, polyolefin, or other materials. Among them, glass is preferred in view of water barrier properties and cost.

In the invention, the solar cell module may be treated with a water-resistant sealant such as silicone rubber or butyl rubber at its end so that the metal corrosion-induced discoloration can be further suppressed. To reduce cost, however, it is preferable to use a frame-less structure without any treatment with a water-resistant sealant at its end. The encapsulant for a solar cell of the invention, which has high anticorrosive properties, is particularly useful in such a frame-less structure.

For the manufacture of the solar cell module, a sheet of the encapsulant for a solar cell of the invention may be made in advance. The module with the structure described above can be formed by a conventionally known method that includes press-bonding the sheet at a temperature where the encapsulant for a solar cell is melted.

A vacuum laminator may be used. In this case, for example, a process may include laminating the encapsulant for a solar cell under a pressure of 1 to 30,000 Pa at a temperature of 100 to 200°C, especially 130 to 170°C, using a known laminator for manufacturing a solar cell module. Specifically, when a vacuum bag or a vacuum ring is used, lamination should be performed under a pressure of about 20,000 Pa at a temperature of 130 to 170°C, for example, as described in EP 1 235 683 B.

Nip rolls may be used. In this case, for example, a process may include performing first temporary press-bonding at a temperature equal to or lower than the temperature at which the polyvinyl acetal begins to flow and then further performing temporary press-bonding under conditions close to the flow beginning temperature. A specific process may include heating the material to 30 to 100°C with an infrared heater or the like, then removing air with rolls, further heating the material to 50 to 150°C, and then press-bonding the material with rolls.

An autoclaving process may be additionally performed after the temporary press-bonding. For example, the autoclaving process is performed under a pressure of about 1 to about 1.5 MPa at a temperature of 130 to 155°C for about 2 hours, although the conditions depend on the thickness and the structure of the solar cell module.

The solar cell module of the invention can be used as a component of windows, walls, roofs, sunrooms, sound barriers, display windows, balconies, handrails, or other members. The solar cell module of the invention can also be used as a partition glass component for conference rooms and a component of home electric appliances. A large number of the solar cell modules of the invention may also be used and arranged to form a photovoltaic power plant.

The laminated glass of the invention may be a laminate including two or more inorganic or organic glass sheets and the interlayer film for laminated glass of the invention placed between the inorganic or organic glass sheets. The interlayer film of the invention for laminated glass is highly anticorrosive. In a useful laminated glass, therefore, at least part of the interlayer film for laminated glass of the invention is in contact with a functional material.

The functional material is preferably a metal-containing functional material, examples of which include a heat sensor, a light sensor, a pressure sensor, a thin-film capacitance sensor, a liquid crystal display film, an electrochromic functional film, a heat shielding material, an electroluminescence functional film, a light-emitting diode, a camera, an IC tag, an antenna, and electrodes and wires for connection thereof.

Any type of glass may be used to form a laminate glass with the interlayer film for laminated glass of the invention. Examples of glass that may be used include inorganic glass such as float plate glass, polished plate glass, figured glass, wired sheet glass, or heat ray absorbing plate glass, and conventionally known organic glass such as polymethyl methacrylate or polycarbonate. These may be colorless or colored and may also be transparent or non-transparent. These glass materials may be used singly or in combination of two or more. The thickness of the glass is preferably, but not limited to, 100 mm or less.

EXAMPLES

Hereinafter, the invention will be described with reference to examples, which however are not intended to limit the invention. The raw materials used in the examples and the comparative examples and the components in the materials were evaluated by the methods described below.

The polyvinyl alcohol (PVA) used in the examples and the comparative examples, the prepared polyvinyl butyral (PVB), and the prepared encapsulant for a solar cell or the prepared interlayer film for laminated glass were measured according to the methods described below.

(Average degree of polymerization of PVA)

The average degree of polymerization of PVA was measured according to JIS K 6726 (1994). The average degree of polymerization of PVB resin is equal to the average degree of polymerization of polyvinyl alcohol used as its raw material.

(Vinyl acetate content of PVB)

The vinyl acetate content of PVB was measured according to JIS K 6728 (1977).

(Vinyl alcohol content of PVB)

The vinyl alcohol content of PVB was measured according to JIS K 6728 (1977).

(Alkali titer of PVB)

An ethanol solution of PVB was subjected to titration with hydrochloric acid, in which the amount of 0.01 mol/L hydrochloric acid required to neutralize 100 g of PVB by titration was measured (as the alkali titer (mL)).

(Acid value of PVB)

The acid value of PVB was measured according to JIS K 6728 (1977).

(Chlorine content of encapsulant for a solar cell or interlayer film for laminated glass)

Ten mL of distilled water and 80 mL of ethanol were added to 1 mL of a 3% by mass nitric acid aqueous solution, and 1 g of a sample of the encapsulant for a solar cell or the interlayer film for laminated glass was precisely weighed and added to the resulting mixture. After the sample was dissolved by stirring, a 0.001 mol/L silver nitrate aqueous solution was added dropwise to the sample solution, and in this process, the chloride ion concentration of the sample was determined as the chlorine content from the titer determined by detecting the change in electric conductivity.

(Preparation Example 1)

A 2 $m^3$ reaction vessel equipped with a stirrer was charged with 1,700 kg of a 7.5% by mass aqueous solution of PVA (1,000 in average degree of polymerization and 99% by mole in degree of saponification), 74.6 kg of butyl aldehyde, and 0.13 kg of 2,6-di-tert-butyl-4-methylphenol, and the whole of the mixture was cooled to 14°C. Butyralization of the PVA was started by adding 160.1 L of a 20% by mass nitric acid aqueous solution to the mixture. Ten minutes after the addition, heating was started. The temperature was raised to 65°C over 90 minutes, and the reaction was further allowed to proceed for 120 minutes. Subsequently, PVB was precipitated by cooling the product to room temperature, filtered, and washed ten times with ion-exchanged water in an amount ten times that of the PVB. Subsequently, the PVB was sufficiently neutralized with a 0.3% by mass sodium hydroxide aqueous solution, and washed ten times with ion-exchanged water in an amount ten times that of the PVB. The PVB (PVB-1) was obtained after dehydration and drying. Table 1 shows the results of the analysis of the obtained PVB.

(Preparation Example 2)

PVB (PVB-2) was obtained as in Preparation Example 1, except that 20% by mass hydrochloric acid was added instead of the nitric acid aqueous solution for the butyralization of PVA. Table 1 shows the results of the analysis of the obtained PVB.

(Preparation Example 3)

A 2 $m^3$ reaction vessel equipped with a stirrer was charged with 1,700 kg of a 7.5% by mass aqueous solution of PVA (1,000 in average degree of polymerization and 99% by mole in degree of saponification), 74.6 kg of butyl aldehyde, and 0.13 kg of 2,6-di-tert-butyl-4-methylphenol, and the whole of the mixture was cooled to 14°C. Butyralization of the PVA was started by adding 160.1 L of 20% by mass hydrochloric acid to the mixture. Ten minutes after the addition, heating was started. The temperature was raised to 65°C over 90 minutes, and the reaction was further allowed to proceed for 120 minutes. Subsequently, PVB was precipitated by cooling the product to room temperature, filtered, and washed 15 times with ion-exchanged water in an amount ten times that of the PVB. Subsequently, the PVB was sufficiently neutralized with a 0.3% by mass sodium hydroxide aqueous solution, and washed 15 times with ion-exchanged water in an amount ten times that of the PVB. The PVB (PVB-3) was obtained after dehydration and drying. Table 1 shows the results of the analysis of the obtained PVB.

(Preparation Example 4)

A 2 m$^3$ reaction vessel equipped with a stirrer was charged with 1,700 kg of a 7.5% by mass aqueous solution of PVA (1,000 in average degree of polymerization and 99% by mole in degree of saponification), 74.6 kg of butyl aldehyde, and 0.13 kg of 2,6-di-tert-butyl-4-methylphenol, and the whole of the mixture was cooled to 14°C. Butyralization of the PVA was started by adding 160.1 L of 20% by mass hydrochloric acid to the mixture. Ten minutes after the addition, heating was started. The temperature was raised to 65°C over 90 minutes, and the reaction was further allowed to proceed for 120 minutes. Subsequently, PVB was precipitated by cooling the product to room temperature, filtered, and washed six times with ion-exchanged water in an amount ten times that of the PVB. Subsequently, the PVB was sufficiently neutralized with a 0.3% by mass sodium hydroxide aqueous solution, and washed six times with ion-exchanged water in an amount ten times that of the PVB. The PVB (PVB-4) was obtained after dehydration and drying. Table 1 shows the results of the analysis of the obtained PVB.

(Preparation Example 5)

A 2 m$^3$ reaction vessel equipped with a stirrer was charged with 1,700 kg of a 7.5% by mass aqueous solution of PVA (1,000 in average degree of polymerization and 99% by mole in degree of saponification), 74.6 kg of butyl aldehyde, and 0.13 kg of 2,6-di-tert-butyl-4-methylphenol, and the whole of the mixture was cooled to 14°C. Butyralization of the PVA was started by adding 160.1 L of 20% by mass hydrochloric acid to the mixture. Ten minutes after the addition, heating was started. The temperature was raised to 65°C over 90 minutes, and the reaction was further allowed to proceed for 120 minutes. Subsequently, PVB was precipitated by cooling the product to room temperature, filtered, and washed three times with ion-exchanged water in an amount ten times that of the PVB. Subsequently, the PVB was sufficiently neutralized with a 0.3% by mass sodium hydroxide aqueous solution, and washed three times with ion-exchanged water in an amount ten times that of the PVB. The PVB (PVB-5) was obtained after dehydration and drying. Table 1 shows the results of the analysis of the obtained PVB.

(Preparation Examples 6 to 11)

Each PVB (each of PVB-6 to PVB-11) was obtained as in Preparation Example 1, except that PVA (99% by mole in degree of saponification) with the same average degree of polymerization as that of PVB shown in Table 1 was used instead. Table 1 shows the results of the analysis of each obtained PVB.

(Preparation Example 12)

A 2 m$^3$ reaction vessel equipped with a stirrer was charged with 1,700 kg of a 7.5% by mass aqueous solution of PVA (600 in average degree of polymerization and 99% by mole in degree of saponification), 80.0 kg of butyl aldehyde, and 0.13 kg of 2,6-di-tert-butyl-4-methylphenol, and the whole of the mixture was cooled to 14°C. Butyralization of the PVA was started by adding 160.1 L of a 20% by mass nitric acid aqueous solution to the mixture. Ten minutes after the addition, heating was started. The temperature was raised to 65°C over 90 minutes, and the reaction was further allowed to proceed for 120 minutes. Subsequently, PVB was precipitated by cooling the product to room temperature, filtered, and washed ten times with ion-exchanged water in an amount ten times that of the PVB. Subsequently, the PVB was sufficiently neutralized with a 0.3% by mass sodium hydroxide aqueous solution, and washed ten times with ion-exchanged water in an amount ten times that of the PVB. The PVB (PVB-12) was obtained after dehydration and drying. Table 1 shows the results of the analysis of the obtained PVB.

Table 1

| PVB | Average degree of polymerization | Vinyl acetate content (mol%) | Vinyl alcohol content (mol%) | Alkali titer (mL) | Acid value of PVB (KOHmg/g) |
|---|---|---|---|---|---|
| PVB-1 | 1000 | 1 | 28.5 | 7 | 0.10 |

(continued)

| PVB | Average degree of polymerization | Vinyl acetate content (mol%) | Vinyl alcohol content (mol%) | Alkali titer (mL) | Acid value of PVB (KOHmg/g) |
|---|---|---|---|---|---|
| PVB-2 | 1000 | 1 | 28.5 | 7 | 0.10 |
| PVB-3 | 1000 | 1 | 28.5 | 7 | 0.10 |
| PVB-4 | 1000 | 1 | 28.5 | 7 | 0.10 |
| PVB-5 | 1000 | 1 | 28.5 | 7 | 0.10 |
| PVB-6 | 500 | 1 | 28.5 | 7 | 0.10 |
| PVB-7 | 600 | 1 | 28.5 | 7 | 0.10 |
| PVB-8 | 700 | 1 | 28.5 | 7 | 0.10 |
| PVB-9 | 1100 | 1 | 28.5 | 7 | 0.10 |
| PVB-10 | 1200 | 1 | 28.5 | 7 | 0.10 |
| PVB-11 | 1700 | 1 | 28.5 | 7 | 0.10 |
| PVB-12 | 600 | 1 | 21.0 | 7 | 0.10 |

(Example 1)

A combination of 25 ppm acetic acid and 175 ppm magnesium acetate (based on the mass of the PVB) was added as a pH-adjusting buffer to the PVB (PVB-1) synthesized in Preparation Example 1. The mixture was pressed under a pressure of 100 kgf/cm$^2$ at a heating plate temperature of 150°C for 10 minutes to form a 0.76-mm-thick PVB sheet (an encapsulant for a solar cell or an interlayer film for laminated glass).

1. Evaluation of physical properties (amount of acid component change after hot water test)

The amount of acid component change after hot water test was determined by the measurement method described herein. As a result, the value A was 0.33 KOHmg/g, which was obtained by dividing, by the mass (in units of g) of the encapsulant for a solar cell or the interlayer film for laminated glass before immersion of the material or the film in hot water at 85°C for 2,000 hours, the mass (in units of mg) of potassium hydroxide required to neutralize acid components present in both of the water and the encapsulant for a solar cell or the interlayer film for laminated glass after the immersion of the material or the film in hot water at 85°C for 2,000 hours, and the value B was 0.14 KOHmg/g, which was obtained by dividing, by the mass (in units of g) of the encapsulant for a solar cell or the interlayer film for laminated glass before the immersion, the mass (in units of mg) of potassium hydroxide required to neutralize acid components present in the encapsulant for a solar cell or the interlayer film for laminated glass before the immersion. The amount of acid component change of the PVB sheet after hot water test was 0.19 KOHmg/g, which was obtained by subtracting the value B from the value A as defined herein.

2. Evaluation of physical properties (water-vapor permeability of sheet)

The water-vapor permeability of the sheet was 9 g/m$^2$·day as measured under the conditions of a temperature of 40°C and a relative humidity of 90% according to JIS Z 0208 (1976).

3. Evaluation of physical properties (laminate quality)

The PVB sheet was sandwiched between two commercially-available float glass sheets (3.2 mm in thickness, 1,100 mm x 1,300 mm in size), and the materials were integrated into a laminated glass under the conditions shown below using a vacuum laminator (1522N manufactured by Nisshinbo Mechatronics Inc.). The laminate quality of the resulting laminated glass was evaluated as "☉" according to the criteria shown below.

<Conditions>

Heating plate temperature: 165°C
Vacuum-application time: 12 minutes
Pressing pressure: 50kPa
Pressing time: 17 minutes
<Criteria>
☉: Good adhesion with no air bubbles, adhesion failure, or other appearance defects
✕: Some air bubbles, adhesion failure, or other appearance defects

4. Evaluation of physical properties (creep resistance)

Samples 1 cm x 8 cm in size with a distance of 4 cm between bench marks were prepared and subjected to a tensile test under the conditions of 85°C, 85%RH, and no load for 5 hours using a creep tester (No. 145 CREEP TESTER manufactured by YASUDA SEIKI SEISAKUSHO, LTD.). After the test, the distance between bench marks was 4.2 cm, and its elongation percentage was 105%. The creep resistance was evaluated according to the following criteria.

<Criteria>
☉: The elongation percentage is 120% or less.
○: The elongation percentage is from more than 120% to 200%.
✕: The elongation percentage is more than 200%.

5. Evaluation of physical properties (length of discolored part after high-temperature, high-humidity test)

A thin-film solar cell and a solar cell module were prepared by the methods described below with reference to Fig. 1. An about 700-nm-thick $SnO_2$ film was formed as a transparent electrode layer 12 on a glass substrate 11 with a size of 100 mm x 100 mm and a thickness of 4 mm by CVD. Amorphous silicon thin films for a photoelectric conversion unit 13 were then formed on the transparent electrode layer 12 over the surface of the substrate using a plasma CVD system. In this process, a p-type amorphous Si film (about 15 nm in thickness), an i-type amorphous Si film (about 500 nm in thickness), and an n-type amorphous Si film (about 3 nm in thickness) were formed as a p-type layer 13a, an i-type layer 13b, and an n-type layer 13c, respectively. A ZnO film (about 80 nm in thickness) and a Ag film (about 200 nm in thickness) were formed as a back electrode 14 over the surface of the substrate by sputtering, so that a solar cell was formed on the glass substrate.

The solar cell formed on the glass substrate was placed on a vacuum laminator (1522N manufactured by Nisshinbo Mechatronics Inc.) in such a manner that the glass substrate was in contact with the heating plate of the laminator. The PVB sheet with a size of 100 mm x 100 mm as a sealing material 15 and a glass substrate 16 with a size of 100 mm x 100 mm and a thickness of 4 mm were placed in this order on the back electrode 14, and the components were integrated into a solar cell module under the following conditions.

<Conditions>

Heating plate temperature: 165°C
Vacuum application time: 12 minutes
Pressing pressure: 50kPa
Pressing time: 17 minutes

The resulting solar cell module was exposed to an environment at 85°C and 85%RH for 2,000 hours. After the exposure, the length of a discolored part of the solar cell, namely, the length of a discolored part after the high-temperature, high-humidity test, was measured from its end. As a result, the measured length was 2.0 mm.

6. Evaluation of physical properties (Rate of decrease in conversion efficiency after high-temperature, high-humidity test)

A solar cell module was prepared using the same process as described above, except that the solar cell was wired so that its electrical characteristics could be measured. Before and after the solar cell module was exposed to an environment at 85°C and 85%RH for 1,000 hours, its conversion efficiency was measured under AM 1.5 standard sunlight irradiation at an intensity of 1,000 W/cm$^2$. The measurement of the conversion efficiency was performed using a solar simulator manufactured by Nisshinbo Mechatronics Inc. The rate (%) of decrease in the conversion efficiency after the exposure was calculated when the conversion efficiency before the exposure was normalized as 100% (reference). As a result, no decrease in the conversion efficiency was observed.

(Examples 2 to 12 and Comparative Examples 1 to 5)

Using materials with the composition shown in Table 2, PVB sheets were prepared by the same method as in Example 1. Using the same methods as in Example 1, the prepared sheets were evaluated for the amount of acid component change after hot water test, the water-vapor permeability, the laminate quality, the creep resistance, the length of the discolored part after high-temperature, high-humidity test, and the rate of decrease in the conversion efficiency after high-temperature, high-humidity test. Table 2 shows the results. The plasticizer used was 3GO (triethylene glycol di(2-ethyl hexanoate) 0.02 KOHmg/g in acid value), and the pH-adjusting buffer used was a combination of 25 ppm acetic acid and 175 ppm magnesium acetate (based on the mass of the PVB).

(Example 13)

A PVB sheet was prepared by the same method as in Example 1, except that no pH-adjusting buffer was added. Using the same methods as in Example 1, the prepared sheet was evaluated for the amount of acid component change after hot water test, the water-vapor permeability, the laminate quality, the creep resistance, the length of the discolored part after high-temperature, high-humidity test, and the rate of decrease in the conversion efficiency after high-temperature, high-humidity test. Table 2 shows the results.

(Comparative Example 6)

A PVB sheet was prepared by the same method as in Comparative Example 3, except that no pH-adjusting buffer was added. Using the same methods as in Example 1, the prepared sheet was evaluated for the amount of acid component change after hot water test, the water-vapor permeability, the laminate quality, the creep resistance, the length of the discolored part after high-temperature, high-humidity test, and the rate of decrease in the conversion efficiency after high-temperature, high-humidity test. Table 2 shows the results.

Table 2

| | | Composition | | | Evaluations | | | | | |
|---|---|---|---|---|---|---|---|---|---|---|
| | Resin | Plasticizer content [1] | Chlorine content [2] | pH-adjusting buffer content [3] | Amount of acid content change after hot water test | Water-vapor permeability | Laminate quality | Creep resistance | Length of discolored part after high-temperature, high-humidity test | Rate of decrease in conversion efficiency after high-temperature, high-humidity test |
| Units | | Parts by mass | ppm | ppm | KOHmg/g | $g/m^2 \cdot 24h$ | | | mm | % |
| Example 1 | PVB-1 | 0 | 1 | 200 | 0.19 | 9 | ⊙ | ⊙ | 2.0 | 0 |
| Example 2 | PVB-1 | 4 | 1 | 200 | 0.19 | 9 | ⊙ | ⊙ | 2.5 | 0 |
| Example 3 | PVB-1 | 10 | 1 | 200 | 0.25 | 10 | ⊙ | ○ | 3.0 | 1 |
| Example 4 | PVB-3 | 0 | 10 | 200 | 0.19 | 9 | ⊙ | ⊙ | 2.5 | 1 |
| Example 5 | PVB-2 | 0 | 20 | 200 | 0.19 | 9 | ⊙ | ⊙ | 3.0 | 1 |
| Example 6 | PVB-6 | 0 | 1 | 200 | 0.19 | 9 | ⊙ | × | 2.0 | 0 |
| Example 7 | PVB-7 | 0 | 1 | 200 | 0.19 | 9 | ⊙ | ○ | 2.0 | 0 |
| Example 8 | PVB-8 | 0 | 1 | 200 | 0.19 | 9 | ⊙ | ○ | 2.0 | 0 |
| Example 9 | PVB-9 | 0 | 1 | 200 | 0.19 | 9 | ⊙ | ⊙ | 2.0 | 0 |
| Example 10 | PVB-10 | 0 | 1 | 200 | 0.19 | 9 | × | ⊙ | 2.0 | 0 |
| Example 11 | PVB-11 | 0 | 1 | 200 | 0.19 | 9 | × | ⊙ | 2.0 | 0 |

(continued)

| | | Composition | | | Evaluations | | | | | |
|---|---|---|---|---|---|---|---|---|---|---|
| | Resin | Plasticizer content [1] | Chlorine content [2] | pH-adjusting buffer content [3] | Amount of acid content change after hot water test | Water-vapor permeability | Laminate quality | Creep resistance | Length of discolored part after high-temperature, high-humidity test | Rate of decrease in conversion efficiency after high-temperature, high-humidity test |
| Units | | Parts by mass | ppm | ppm | KOHmg/g | g/m²·24h | | | mm | % |
| Example 12 | PVB-12 | 0 | 1 | 200 | 0.19 | 9 | ⊙ | ⊙ | 2.0 | 0 |
| Example 13 | PVB-1 | 0 | 1 | 0 | 1.50 | 9 | ⊙ | ⊙ | 5.0 | 4 |
| Comparative Example 1 | PVB-1 | 20 | 1 | 200 | 0.30 | 19 | ⊙ | × | 7.0 | 10 |
| Comparative Example 2 | PVB-2 | 20 | 20 | 200 | 0.30 | 19 | ⊙ | × | 14.0 | 12 |
| Comparative Example 3 | PVB-2 | 35 | 20 | 200 | 0.35 | 59 | ⊙ | × | 19.0 | 14 |
| Comparative Example 4 | PVB-4 | 0 | 30 | 200 | 0.19 | 9 | ⊙ | ⊙ | 6.0 | 6 |
| Comparative Example 5 | PVB-5 | 0 | 100 | 200 | 0.19 | 9 | ⊙ | ⊙ | 9.0 | 11 |
| Comparative Example 6 | PVB-2 | 35 | 20 | 0 | 2.05 | 59 | ⊙ | × | 19.5 | 15 |

1) Content based on 100 parts by mass of PVB
2) Content based on the total mass of PVB sheet
3) Content based on the mass of PVB

EP 2 728 625 B1

17

A comparison between the examples and the comparative examples shows that plasticizer content reduction is important to reduce the water-vapor permeability. It is also apparent that both plasticizer content reduction and chlorine content reduction are important to reduce the length of the discolored part after high-temperature, high-humidity test. It is also apparent that the solar cell module prepared using the PVB sheet shown in each of the examples has a short length of the discolored part after high-temperature, high-humidity test, in other words, is less corroded at its metal component, and thus shows a smaller decrease in power generation efficiency and has a long life.

INDUSTRIAL APPLICABILITY

The encapsulant for a solar cell of the invention is less corrosive to metal components even when ends are not treated with any water-resistant sealant. Thus, the encapsulant for a solar cell of the invention is useful as a sealant for forming a long-life solar cell module that is less likely to be discolored even when used for a long period of time at high temperature and high humidity. Even when used together with a functional material such as a heat shielding material or an electrochromic material, the interlayer film of the invention for laminated glass can suppress the corrosion of such a material. Thus, the interlayer film of the invention is useful to form laminated glass products that are less likely to be discolored, have high quality, and have high durability so that they will not undergo delamination over a long period of time.

REFERENCE SIGNS LIST

11:    Glass substrate
12:    Transparent electrode layer
13:    Photoelectric conversion unit
13a:    p-type layer
13b:    i-type layer
13c:    n-type layer
14:    Back electrode
15:    Encapsulant
16:    Glass substrate

**Claims**

1.    An encapsulant for a solar cell or an interlayer film for laminated glass, comprising a material having a polyvinyl acetal content of 40% by mass or more and a chlorine content of 25 ppm or less and having a plasticizer content of 10 parts by mass or less based on 100 parts by mass of polyvinyl acetal,.

2.    The encapsulant for a solar cell or the interlayer film for laminated glass according to claim 1, wherein the polyvinyl acetal has an average degree of polymerization of 100 to 5,000.

3.    The encapsulant for a solar cell or the interlayer film for laminated glass according to claim 1 or 2, wherein the polyvinyl acetal has an average degree of polymerization of 600 to 1,500.

4.    The encapsulant for a solar cell or the interlayer film for laminated glass according to any one of claims 1 to 3, which has an amount of acid component change of at most 1.00 KOHmg/g after hot water test, wherein the amount of acid component change is expressed by formula (1):
[Mathematical Formula 1]

$$\text{(Amount of acid component change after hot water test)} = A - B \quad (1)$$

[wherein, in above formula (1), A represents a value (in units of KOHmg/g) obtained by dividing, by the mass (in units of g) of the encapsulant for a solar cell or the interlayer film for laminated glass before immersion of the material or the film in hot water at 85°C for 2,000 hours, the mass (in units of mg) of potassium hydroxide required to neutralize acid components present in both of the water and the encapsulant for a solar cell or the interlayer film for laminated glass after the immersion of the material or the film in hot water at 85°C for 2,000 hours, and B represents a value (in units of KOHmg/g) obtained by dividing, by the mass (in units of g) of the encapsulant for a solar cell or the interlayer film for laminated glass before the immersion, the mass (in units of mg) of potassium hydroxide required to neutralize acid components present in the encapsulant for a solar cell or the interlayer film for laminated glass before the immersion.]

5. A method for producing the encapsulant for a solar cell or the interlayer film for laminated glass according to any one of claims 1 to 4, comprising performing acetalization of polyvinyl alcohol with an aldehyde to obtain the polyvinyl acetal, wherein a chlorine-free catalyst are used in the acetalization.

6. The method for producing the encapsulant for a solar cell or the interlayer film for laminated glass according to claim 5, wherein the chlorine-free catalyst is nitric acid.

7. A solar cell module comprising the encapsulant for a solar cell according to any one of claims 1 to 4.

8. The solar cell module according to claim 7, further comprising a metal layer, wherein at least part of the encapsulant for a solar cell is in contact with the metal layer.

9. A laminated glass comprising the interlayer film for laminated glass according to any one of claims 1 to 4.

10. The laminated glass according to claim 9, further comprising a functional material, wherein at least part of the interlayer film for laminated glass is in contact with the functional material.


**Patentansprüche**

1. Verkapselung für eine Solarzelle oder Zwischenschichtfolie für Verbundglas, die ein Material mit einem Polyvinylacetalgehalt von mindestens 40 Masse-% und einem Chlorgehalt von maximal 25 ppm aufweist und mit einem Weichmachergehalt von maximal 10 Masseteilen auf Basis von 100 Masseteilen Polyvinylacetal umfasst.

2. Verkapselung für eine Solarzelle oder Zwischenschichtfolie für Verbundglas nach Anspruch 1, wobei das Polyvinylacetal einen durchschnittlichen Polymerisationsgrad von 100 bis 5.000 aufweist.

3. Verkapselung für eine Solarzelle oder Zwischenschichtfolie für Verbundglas nach Anspruch 1 oder 2, wobei das Polyvinylacetal einen durchschnittlichen Polymerisationsgrad von 600 bis 1.500 aufweist.

4. Verkapselung für eine Solarzelle oder Zwischenschichtfolie für Verbundglas nach einem der Ansprüche 1 bis 3, die einen Betrag der Säurekomponentenänderung von höchstens 1,00 KOH mg/g nach Warmwassertest aufweist, wobei der Betrag der Säurekomponentenänderung mit der Formel (1) ausgedrückt wird:
[Mathematische Formel 1]

$$(\text{Betrag der Säurekomponentenänderung nach Warmwassertest}) = A - B \quad (1)$$

[wobei in der vorstehenden Formel (1) A einen Wert (in der Einheit KOH mg/g) darstellt, der durch Teilen der Masse (in der Einheit mg) von Kaliumhydroxid, die zum Neutralisieren von sowohl im Wasser als auch in der Verkapselung für eine Solarzelle oder der Zwischenschichtfolie für Verbundglas vorhandenen Säurekomponenten benötigt wird, nach dem Eintauchen des Materials oder der Folie in heißes Wasser bei 85 °C für 2000 Stunden durch die Masse (in der Einheit g) der Verkapselung für eine Solarzelle oder der Zwischenschichtfolie für Verbundglas vor dem Eintauchen des Materials oder der Folie in heißes Wasser bei 85 °C für 2000 Stunden erhalten wird, und B einen Wert (in der Einheit KOH mg/g) darstellt, der durch Teilen der Masse (in der Einheit mg) von Kaliumhydroxid, die zum Neutralisieren von in der Verkapselung für eine Solarzelle oder der Zwischenschichtfolie für Verbundglas vorhandenen Säurekomponenten benötigt wird, durch die Masse (in der Einheit g) der Verkapselung für eine Solarzelle oder der Zwischenschichtfolie für Verbundglas vor dem Eintauchen erhalten wird.]

5. Verfahren zur Herstellung der Verkapselung für eine Solarzelle oder der Zwischenschichtfolie für Verbundglas nach einem der Ansprüche 1 bis 4, umfassend ein Durchführen einer Acetalisierung von Polyvinylalkohol mit einem Aldehyd zur Gewinnung des Polyvinylacetals, wobei ein chlorfreier Katalysator bei der Acetalisierung eingesetzt wird.

**6.** Verfahren zur Herstellung der Verkapselung für eine Solarzelle oder der Zwischenschichtfolie für Verbundglas nach Anspruch 5, wobei der chlorfreie Katalysator Salpetersäure ist.

**7.** Solarmodul, umfassend die Verkapselung für eine Solarzelle nach einem der Ansprüche 1 bis 4.

**8.** Solarmodul nach Anspruch 7, ferner umfassend eine Metallschicht, wobei zumindest ein Teil der Verkapselung für eine Solarzelle die Metallschicht berührt.

**9.** Verbundglas, umfassend die Zwischenschichtfolie für Verbundglas nach einem der Ansprüche 1 bis 4.

**10.** Verbundglas nach Anspruch 9, ferner umfassend einen Funktionswerkstoff, wobei zumindest ein Teil der Zwischenschichtfolie für Verbundglas den Funktionswerkstoff berührt.

**Revendications**

**1.** Encapsulant pour une cellule solaire ou film intercalaire pour verre feuilleté, comprenant un matériau ayant une teneur en polyvinylacétal de 40 % en masse ou plus et une teneur en chlore de 25 ppm ou moins et ayant une teneur en plastifiant de 10 parties en masse ou moins pour 100 parties en masse de polyvinylacétal.

**2.** Encapsulant pour une cellule solaire ou film intercalaire pour verre feuilleté selon la revendication 1, dans lesquels le polyvinylacétal a un degré moyen de polymérisation de 100 à 5000.

**3.** Encapsulant pour une cellule solaire ou film intercalaire pour verre feuilleté selon la revendication 1 ou 2, dans lesquels le polyvinylacétal a un degré moyen de polymérisation de 600 à 1500.

**4.** Encapsulant pour une cellule solaire ou film intercalaire pour verre feuilleté selon l'une quelconque des revendications 1 à 3, qui ont une quantité de variation de constituants acides de 1,00 mg KOH/g maximum après un essai à l'eau chaude, la quantité de variation de constituants acides étant exprimée par la formule (1) :
[Formule mathématique 1]

$$\text{(Quantité de variation de constituants acides après essai à l'eau chaude)} = A - B \ (1)$$

[dans lesquels, dans la formule (1) ci-dessus, A représente une valeur (en mg KOH/g) obtenue en divisant, par la masse (en g) de l'encapsulant pour une cellule solaire ou du film intercalaire pour verre feuilleté avant immersion du matériau ou du film dans de l'eau chaude à 85 °C pendant 2000 heures, la masse (en mg) d'hydroxyde de potassium nécessaire pour neutraliser les constituants acides présents à la fois dans l'eau et l'encapsulant pour une seule solaire ou le film intercalaire pour verre feuilleté après l'immersion du matériau ou du film dans de l'eau chaude à 85 °C pendant 2000 heures, et B représente une valeur (en mg KOH/g) obtenue en divisant, par la masse (en g) de l'encapsulant pour une cellule solaire ou du film intercalaire pour verre feuilleté avant l'immersion, la masse (en mg) d'hydroxyde de potassium nécessaire pour neutraliser les constituants acides présents dans l'encapsulant pour une cellule solaire ou le film intercalaire pour verre feuilleté avant l'immersion].

**5.** Procédé de production de l'encapsulant pour une cellule solaire ou du film intercalaire pour verre feuilleté selon l'une quelconque des revendications 1 à 4, comprenant la réalisation d'une acétalisation d'alcool polyvinylique avec un aldéhyde pour obtenir le polyvinylacétal, un catalyseur sans chlore étant utilisé dans l'acétalisation.

**6.** Procédé de production de l'encapsulant pour une cellule solaire ou du film intercalaire pour verre feuilleté selon la revendication 5, dans lequel le catalyseur sans chlore est l'acide nitrique.

**7.** Module de cellules solaires comprenant l'encapsulant pour une cellule solaire selon l'une quelconque des revendications 1 à 4.

**8.** Module de cellules solaires selon la revendication 7, comprenant en outre une couche métallique, au moins une partie de l'encapsulant pour une cellule solaire étant en contact avec la couche métallique.

9. Verre feuilleté comprenant le film intercalaire pour verre feuilleté selon l'une quelconque des revendications 1 à 4.

10. Verre feuilleté selon la revendication 9, comprenant en outre un matériau fonctionnel, au moins une partie du film intercalaire pour verre feuilleté étant en contact avec le matériau fonctionnel.

[FIG. 1]

11
12
13a ⎫
13b ⎬ 13
13c ⎭
14
15
16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 58023870 A
- JP 6177412 A
- JP 2006013505 A
- WO 2009151952 A2
- WO 03033583 A
- EP 1235683 B

**Non-patent literature cited in the description**

- Polyvinyl Butyral Testing Methods. *JIS K 6728,* 1977
- *JIS K 6728,* 1977